# EUROPEAN PATENT APPLICATION

(11) **EP 4 773 753 A1**
(43) Date of publication of application: **08.07.2026**
(21) Application number: 25210322.1
(22) Date of filing: 22.10.2025
(51) Int. Cl.: H10B 43/27, H10B 43/35, H10D 30/67, H10D 30/69, H10D 64/01

(54) **SEMICONDUCTOR DEVICE AND METHOD OF MANUFACTURING SEMICONDUCTOR DEVICE**

(30) Priority: 24.12.2024 KR 20240196055
(71) Applicant: SK hynix Inc., Bubal-eub Icheon-si Gyeonggi-do 17336 (KR)
(72) Inventor: CHOI, Jung Dal, Icheon-si, Gyeonggi-do (KR); PARK, In Su, Icheon-si, Gyeonggi-do (KR); YANG, Na Yeong, Icheon-si, Gyeonggi-do (KR); JANG, Jung Shik, Icheon-si, Gyeonggi-do (KR)
(74) Representative: Isarpatent

(57) **Abstract**

A semiconductor device includes a gate structure including a source select line, a drain select line, and word lines stacked between the source select line and the drain select line; a second channel layer penetrating through the source select line and including polysilicon; a third channel layer penetrating through the drain select line and including polysilicon; a first channel layer penetrating through the word lines, connected between the second channel layer and the third channel layer, and including molybdenum disulfide (MoS₂); and an insulating core disposed inside the first channel layer.

## Description

### BACKGROUND

### 1. Technical Field

Embodiments of the present disclosure relate to an electronic device, and more particularly, to a semiconductor device and a method of manufacturing the semiconductor device.

### 2. Related Art

The degree of integration of a semiconductor device is mainly determined by an area occupied by a unit memory cell. Recently, as the improvement in the degree of integration of a semiconductor device for forming memory cells in a single layer on a substrate reaches a limit, a three-dimensional semiconductor device for stacking memory cells on a substrate has been proposed. Furthermore, to improve the operational reliability of such a semiconductor device, various structures and manufacturing methods have been developed.

### SUMMARY

In an embodiment of the present disclosure, a semiconductor device may include a gate structure including a source select line, a drain select line, and word lines stacked between the source select line and the drain select line; first, second and third channel layers; and an insulating core disposed inside the first channel layer, wherein the second channel layer penetrates through the source select line and includes polysilicon; wherein the third channel layer penetrates through the drain select line and includes polysilicon; and wherein the first channel layer penetrates through the word lines, connected between the second channel layer and the third channel layer, and includes molybdenum disulfide (MoS₂).

In an embodiment of the present disclosure, a semiconductor device may include a gate structure including conductive layers and insulating layers that are alternately stacked; an insulating core extending through the gate structure; a first channel layer surrounding the insulating core, disposed between the insulating core and the gate structure, and including molybdenum disulfide (MoS₂); and a second channel layer including a source portion extending along a surface of the gate structure and a channel portion extending into the gate structure and connected to the first channel layer, and including polysilicon.

In an embodiment of the present disclosure, a method of manufacturing a semiconductor device may include forming a stack including first material layers and second material layers that are alternately stacked; forming a first channel layer extending through the stack and including molybdenum disulfide (MoS₂); forming an insulating core in the first channel layer; exposing sidewalls of the insulating core by etching the first channel layer; and forming a third channel layer above the first channel layer and the insulating core.

In an embodiment of the present disclosure, a method of manufacturing a semiconductor device may include forming a stack including first material layers and second material layers that are alternately stacked; forming a first channel layer extending through the stack and including molybdenum disulfide (MoS₂); forming an insulating core in the first channel layer; and forming a second channel layer including a source portion extending along a surface of the stack and a channel portion protruding from the source portion and connected to the first channel layer.

In an embodiment of the present disclosure, a method of manufacturing a semiconductor device may include forming a first wafer including a substrate, a gate structure disposed on the substrate, a first channel layer extending into the substrate through the gate structure and including molybdenum disulfide (MoS₂), and an insulating core disposed inside the first channel layer; forming a second wafer including a peripheral circuit; bonding the first wafer and the second wafer to each other; removing the substrate so that the first channel layer protrudes from a surface of the gate structure; forming an opening by etching the first channel layer; and forming a second channel layer on the insulating core and the first channel layer, the second channel layer being connected to the first channel layer and including polysilicon.

### BRIEF DESCRIPTION OF THE DRAWINGS

FIGS. 1A and 1B are simplified diagrams illustrating the structure of a semiconductor device in accordance with an embodiment of the present disclosure.
FIGS. 2A and 2B are simplified diagrams for describing the characteristics of a semiconductor device in accordance with an embodiment of the present disclosure.
FIGS. 3A to 3E are simplified diagrams illustrating the structure of a semiconductor device in accordance with an embodiment of the present disclosure.
FIGS. 4A and 4B are simplified diagrams for describing the characteristics of a semiconductor device in accordance with an embodiment of the present disclosure.
FIG. 5 is a diagram illustrating the structure of a semiconductor device in accordance with an embodiment of the present disclosure.
FIG. 6 is a diagram illustrating the structure of a semiconductor device in accordance with an embodiment of the present disclosure.
FIGS. 7A to 7D are simplified diagrams for describing a method of manufacturing a semiconductor device in accordance with an embodiment of the present disclosure.
FIGS. 8A to 8F are simplified diagrams for describing a method of manufacturing a semiconductor device in accordance with an embodiment of the present disclosure.
FIGS. 9A to 9D are simplified diagrams for describing a method of manufacturing a semiconductor device in accordance with an embodiment of the present disclosure.
FIGS. 10A to 10D are simplified diagrams for describing a method of manufacturing a semiconductor device in accordance with an embodiment of the present disclosure.
FIGS. 11A to 11C are simplified diagrams for describing a method of manufacturing a semiconductor device in accordance with an embodiment of the present disclosure.
FIGS. 12A to 12C are simplified diagrams for describing a method of manufacturing a semiconductor device in accordance with an embodiment of the present disclosure.
FIG. 13 is a configuration diagram of a semiconductor device in accordance with an embodiment of the present disclosure.
FIG. 14 is a configuration diagram of a semiconductor device in accordance with an embodiment of the present disclosure.

### DETAILED DESCRIPTION

Various embodiments of the present disclosure are directed to a semiconductor device having a stable structure and improved characteristics and a method of manufacturing the semiconductor device.

By stacking memory cells in three dimensions, it is possible to improve the degree of integration of a semiconductor device. It is also possible to provide a semiconductor device having a stable structure and improved reliability.

Hereafter, embodiments in accordance with the technical spirit of the present disclosure will be described with reference to the accompanying drawings.

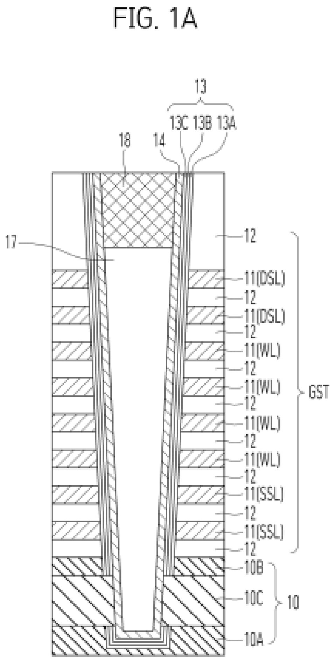

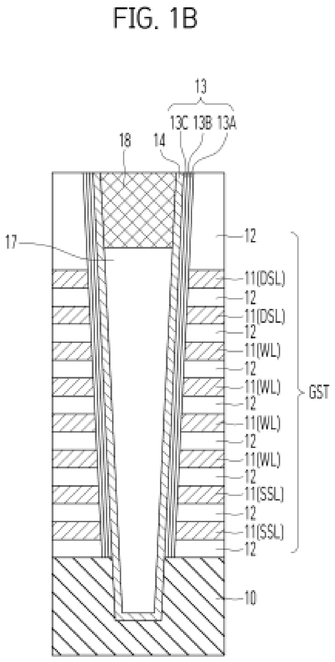

FIGS. 1A and 1B are simplified diagrams illustrating the structure of a semiconductor device in accordance with an embodiment of the present disclosure.

Referring to FIGS. 1A and 1B, the semiconductor device may include a gate structure GST, a first channel layer 14, an insulating core 17, and a channel pad 18. The semiconductor device may further include a source structure 10 and a memory layer 13.

The gate structure GST may include conductive layers 11 and insulating layers 12 that are alternately stacked. At least one conductive layer 11 disposed at the lowermost portion may be a source select line SSL, at least one conductive layer 11 disposed at the uppermost portion may be a drain select line DSL, and the remaining conductive layers 11 may be word lines WL. The word lines WL may be stacked between the source select lines SSL and the drain select lines DSL. For reference, the terms "upper portion" and "lower portion" are relative concepts, and it is also possible for the source select line SSL to be disposed at the upper portion and for the drain select line DSL to be disposed at the lower portion.

The first channel layer 14 may extend through the gate structure GST and also extend into the source structure 10 at least partially. The first channel layer 14 may include a two-dimensional semiconductor material. As an example, the first channel layer 14 may include molybdenum disulfide (MoS₂). The first channel layer 14 may include MoS₂ formed as a monolayer of an atomic thickness. Alternatively, the first channel layer 14 may include MoS₂ in a bulk state in which monolayers are stacked.

The memory layer 13 may surround the sidewalls of the first channel layer 14. The memory layer 13 may be disposed between the first channel layer 14 and the gate structure GST. The memory layer 13 may also be disposed between the first channel layer 14 and an upper part of the source structure 10, e.g., second source layer 10B as shown in FIG. 1A. The memory layer 13 may include at least one of a blocking layer 13A, a data storage layer 13B, and a tunneling layer 13C. The data storage layer 13B may be disposed between the blocking layer 13A and the tunneling layer 13C. The tunneling layer 13C may contact the first channel layer 14. The blocking layer 13A may contact the sides of the conductive and insulating layers 11, 12 of the gate structure GST. The data storage layer 13B may include a floating gate, polysilicon, a charge trap material, nitride, a variable resistance material, or the like.

The insulating core 17 may include an insulating material such as oxide. The insulating core 17 may be disposed inside the first channel layer 14. The insulating core 17 may extend into the source structure 10 through the gate structure GST. An upper surface of the insulating core 17 may be disposed higher than an upper surface of the uppermost conductive layer 11. An upper surface of the insulating core 17 may be disposed lower than an upper surface of the uppermost insulating layer 12.

The channel pad 18 may be disposed above the insulating core 17. The channel pad 18 may be disposed inside the first channel layer 14, and may contact the inner walls of the first channel layer 14. A lower surface of the channel pad 18 may be disposed higher than the upper surface of the uppermost conductive layer 11. As an example, the channel pad 18 may not overlap with the drain select lines DSL. For example, the channel pad 18 may include polysilicon.

The source structure 10 may be disposed below the gate structure GST. The first channel layer 14 and the insulating core 17 may extend into the source structure 10 through the gate structure GST. The source structure 10 may have a single-layer structure or a multilayer structure. Referring to FIG. 1A, the source structure 10 may include a first source layer 10A, a second source layer 10B, and a third source layer 10C disposed between the first source layer 10A and the second source layer 10B. The third source layer 10C may penetrate through the memory layer 13 and be connected to the first channel layer 14. The third source layer 10C may contact the first channel layer 14. The first source layer 10A, and the second source layer 10B may not contact the first channel layer 14. The first, second and third source layers 10A, 10B, and 10C may each include polysilicon. Referring to FIG. 1B, the source structure 10 may surround the first channel layer 14, and may be a polysilicon layer.

According to the structure described above, select transistors or memory cells may be disposed in regions where the first channel layer 14 and the conductive layers 11 intersect each other. Source select transistors may be disposed in regions where the first channel layer 14 and the source select lines SSL intersect each other. Drain select transistors may be disposed in regions where the first channel layer 14 and the drain select lines DSL intersect each other. The memory cells may be disposed in regions where the first channel layer 14 and the word lines WL intersect each other. The source select transistors, the drain select transistors, and the memory cells that share the first channel layer 14 with each other may be connected to each other in series, and may constitute one memory string. Because the first channel layer 14 includes MoS₂, electron mobility may be increased, and a cell current may be improved.

Because the channel pad 18 is formed inside the first channel layer 14, the first channel layer 14 has a structure in which it surrounds sidewalls of the channel pad 18. When the channel pad 18 is disposed above the first channel layer 14 and the lower surface of the channel pad 18 and an upper surface of the first channel layer 14 are in contact with each other, the channel pad 18 is included in a main current path. The channel pad 18 including polysilicon has lower electron mobility than the first channel layer 14 including MoS₂. In addition, resistance of the current path is high due to scattering caused by a crystal structure of polysilicon. Accordingly, the channel pad 18 is formed to contact the inner walls of the first channel layer 14, such that the channel pad 18 does not directly participate in the current path, and the first channel layer 14 may be used as the main current path. Accordingly, the cell current may be improved, and the operation characteristics of the semiconductor device may be improved.

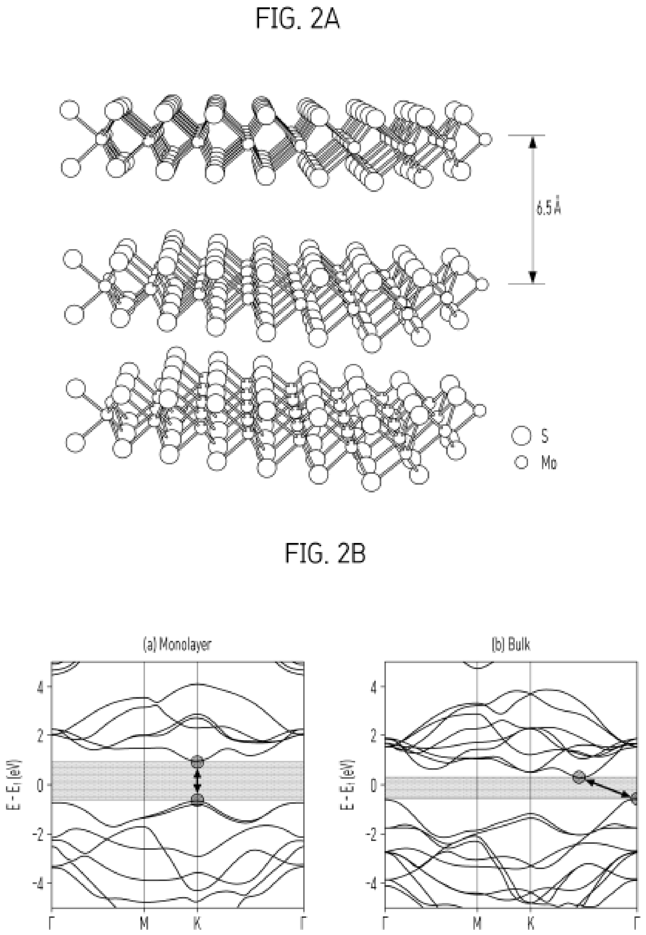

FIGS. 2A and 2B are simplified diagrams for describing the characteristics of a semiconductor device in accordance with an embodiment of the present disclosure. FIG. 2A is a diagram illustrating an atomic structure of MoS₂, and FIG. 2B is a diagram illustrating a change in energy band gap according to stacking of MoS₂.

Referring to FIG. 2A, MoS₂ has a two-dimensional structure. MoS₂ does not have an electron scattering effect due to its crystal structure, and is thus advantageous for electron movement. Accordingly, by forming the first channel layer 14 with MoS₂, it is possible to improve electron mobility, and it is possible to improve a cell current. Because MoS₂ may be formed as a monolayer of an atomic thickness, a thickness of the first channel layer 14 may be reduced to improve the degree of integration of the semiconductor device. MoS₂ has a high electron affinity and a great energy band gap, and may be thus advantageous for doping N-type impurities.

FIG. 2B (a) is a graph illustrating the characteristics of MoS₂ having a monolayer state, and FIG. 2B (b) is a graph illustrating the characteristics of MoS₂ having a bulk state. The x-axis of each graph is a waver vector (k), and represents the movement of electrons within a periodic lattice. The y-axis of each graph represents an energy level.

In the graphs, each curve represents energy of an electron along a specific path, and represents an energy change of the electron. An arrow represents the lowest energy transition between a conduction band and a valence band, and a shaded region represents an energy band gap.

Referring to FIG. 2A and FIG. 2B (a), in MoS₂ in the monolayer state, electrons and holes move only within a plane, and a quantum confinement effect strongly acts. The lowest point of the conduction band is disposed immediately above the highest point of the valence band, and a gap between electron levels becomes great. Accordingly, MoS₂ of the monolayer has a relatively great energy band gap of about 1.8 eV, and has a direct band gap. Because MoS₂ of the monolayer has a wider band gap than silicon, it may have a small leakage current and maintain stable performance even in a high-temperature environment.

Referring to FIG. 2A and FIG. 2B (b), in MoS₂ in the bulk state in which monolayers are stacked, electrons and holes freely move within a three-dimensional structure, and rearrangement of an energy band occurs due to an interlayer interaction. As the lowest point of the conduction band moves, an energy gap decreases. Accordingly, MoS₂ in the bulk state has a relatively small energy band gap of 1.2 eV, and has an indirect band gap.

Accordingly, a state of MoS₂ included in the first channel layer 14 may be determined in consideration of the electron mobility, the electron affinity, the energy band gap, and the like, of MoS₂. The first channel layer 14 may have a monolayer state or a bulk state in consideration of operation characteristics of the source select transistor, the drain select transistor, or the memory cell. As an example, the first channel layer 14 may have a monolayer state as a whole or a bulk state as a whole. Alternatively, the first channel layer 14 corresponding to the memory cell may have a monolayer state and the first channel layer 14 corresponding to the source/drain select transistor may have a bulk state.

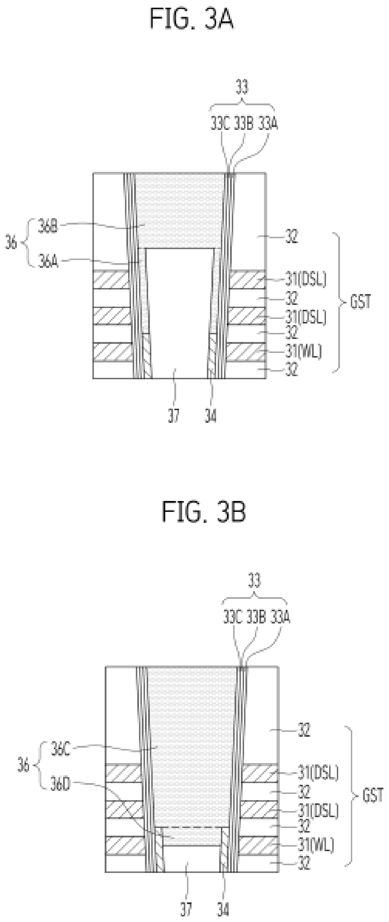

FIGS. 3A to 3E are simplified diagrams illustrating the structure of a semiconductor device in accordance with an embodiment of the present disclosure. Hereinafter, any content overlapping with the previously described content may be omitted.

Referring to FIGS. 3A to 3E, the semiconductor device may include a gate structure GST, a first channel layer 34, a second channel layer 35, a third channel layer 36, a memory layer 33, and an insulating core 37. The gate structure GST may include conductive layers 31 and insulating layers 32 that are alternately stacked. The memory layer 33 may surround the first channel layer 34, the second channel layer 35, and the third channel layer 36. The memory layer 33 may include at least one of a blocking layer 33A, a data storage layer 33B, and a tunneling layer 33C.

The first channel layer 34 may penetrate through word lines WL. The first channel layer 34 may surround the insulating core 37, and may be disposed between the insulating core 37 and the gate structure GST. The second channel layer 35 may penetrate through source select lines SSL, and the third channel layer 36 may penetrate through drain select lines DSL. The first channel layer 34 may be connected between the second channel layer 35 and the third channel layer 36. The second channel layer 35 may be disposed at a lower portion and the third channel layer 36 may be disposed at an upper portion or the second channel layer 35 may be disposed at an upper portion and the third channel layer 36 may be disposed at a lower portion.

The second channel layer 35 and the third channel layer 36 may each include a different material from the first channel layer 34. The first channel layer 34 may include a material having a higher electron mobility than the second channel layer 35 and the third channel layer 36. The first channel layer 34 may include a material having a greater energy band gap than the second channel layer 35 and the third channel layer 36 or a material having a similar energy band gap to the second channel layer 35 and the third channel layer 36. The first channel layer 34 may include a material having a higher electron affinity to the second channel layer 35 and the third channel layer 36. As an example, the first channel layer 34 may include MoS₂, and the second channel layer 35 and the third channel layer 36 may each include polysilicon.

For reference, it is also possible for the semiconductor device to include the first channel layer 34 and the second channel layer 35 and not to include the third channel layer 36. In such a case, the first channel layer 34 may penetrate through the word lines WL and the drain select lines DSL. Alternatively, it is also possible for the semiconductor device to include the first channel layer 34 and the third channel layer 36 and not to include the second channel layer 35. In such a case, the first channel layer 34 may penetrate through the word lines WL and the source select lines SSL.

Referring to FIG. 3A, the third channel layer 36 may include a channel portion 36A and a pad portion 36B. The pad portion 36B may be disposed above the insulating core 37. The channel portion 36A may be connected to the pad portion 36B, and may protrude from a lower surface of the pad portion 36B. The insulating core 37 may extend to the inside of the third channel layer 36, and the channel portion 36A may extend along sidewalls of the insulating core 37. The channel portion 36A may penetrate through the drain select lines DSL, and may be directly connected to the first channel layer 34.

Referring to FIG. 3B, the third channel layer 36 may include a channel portion 36C and a protrusion portion 36D. The channel portion 36C may be disposed above the insulating core 37 and the first channel layer 34, and may penetrate through the drain select lines DSL. The protrusion portion 36D may protrude from a lower surface of the channel portion 36C to the inside of the first channel layer 34. The protrusion portion 36D may contact inner walls of the first channel layer 34. Through the protrusion portion 36D, a contact area between the third channel layer 36 and the first channel layer 34 may be increased, and contact resistance between the third channel layer 36 and the first channel layer 34 may be reduced.

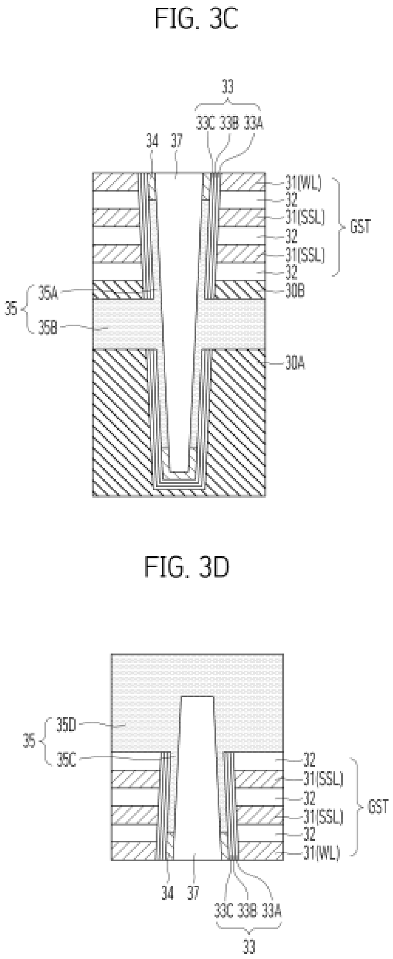

Referring to FIG. 3C, the second channel layer 35 may include a channel portion 35A and a source portion 35B. The insulating core 37 may extend to the inside of the second channel layer 35. The channel portion 35A may surround the insulating core 37 and extend between the insulating core 37 and the gate structure GST. The channel portion 35A may protrude from the source portion 35B, and may penetrate through the source select lines SSL. The channel portion 35A may extend into the gate structure GST and be connected to the first channel layer 34. The source portion 35B may extend along a surface of the gate structure GST. The source portion 35B may be connected to the channel portion 35A, and may be disposed below the gate structure GST.

A first source layer 30A may be disposed below the source portion 35B, and a second source layer 30B may be disposed between the source portion 35B and the gate structure GST. The first source layer 30A and the second source layer 30B may be disposed below the gate structure GST, and the source portion 35B may be disposed between the first source layer 30A and the second source layer 30B. The source portion 35B may be used as a source structure together with the first source layer 30A and the second source layer 30B. Accordingly, the second channel layer 35 may function as both a channel layer and a source layer.

Referring to FIG. 3D, the second channel layer 35 may include a channel portion 35C and a source portion 35D. The insulating core 37 may extend to the inside of the second channel layer 35. The channel portion 35C may surround the insulating core 37 and extend between the insulating core 37 and the gate structure GST. The channel portion 35C may protrude from a lower surface of the source portion 35D. The channel portion 35C may penetrate through the source select lines SSL, and may be connected to the first channel layer 34. The source portion 35D may extend along a surface of the gate structure GST. The source portion 35D may be connected to the channel portion 35C and may be disposed above the gate structure GST. The second channel layer 35 may function as both a channel layer and a source layer.

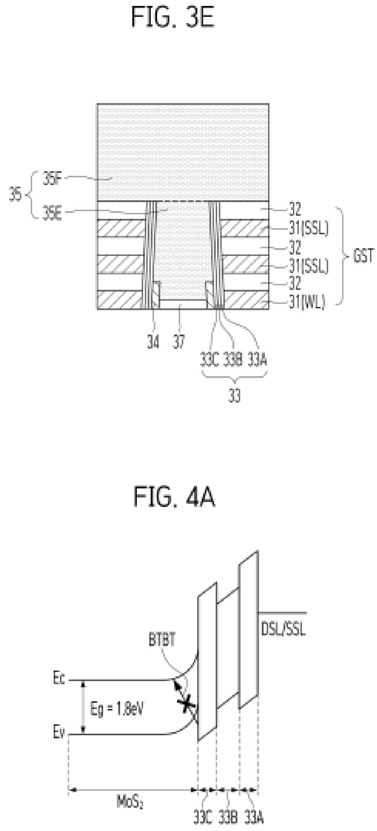

Referring to FIG. 3E, the second channel layer 35 may include a channel portion 35E and a source portion 35F. The source portion 35F may be disposed above the gate structure GST, and may extend along a surface of the gate structure GST. The channel portion 35E may protrude from a lower surface of the source portion 35F. The channel portion 35E may extend through the gate structure GST, and may penetrate through the source select lines SSL. The channel portion 35E may contact inner walls of the first channel layer 34. The second channel layer 35 may function as both a channel layer and a source layer.

According to the structure described above, the semiconductor device may include the first channel layer 34 including MoS₂, the second channel layer 35 including polysilicon, and the third channel layer 36 including polysilicon or a combination thereof. Accordingly, it is possible to improve a cell current and improve the characteristics of an erase operation.

For reference, it is also possible for the semiconductor device to include at least one of the first channel layer 14 according to an embodiment described with reference to FIGS. 1A and 1B and the first channel layer 34, the second channel layer 35, and the third channel layer 36 described with reference to FIGS. 3A to 3E or a combination thereof.

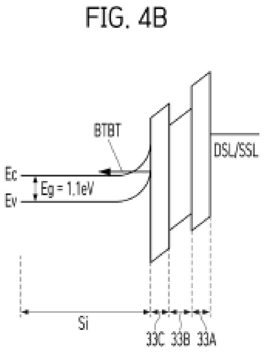

FIGS. 4A and 4B are simplified diagrams for describing the characteristics of a semiconductor device in accordance with an embodiment of the present disclosure. FIG. 4A is a diagram for describing gate induced drain leakage (GIDL) characteristics of a select transistor including a MoS₂ channel layer, and FIG. 4B is a diagram for describing GIDL characteristics of a select transistor including a polysilicon channel layer.

The semiconductor device may perform an erase operation in a GIDL manner. According to the GIDL manner, the erase operation is performed by generating a GIDL current in a source select transistor and/or a drain select transistor by band to band tunneling (BTBT) and by supplying holes to a memory cell. Accordingly, by supplying a sufficient amount of holes, it is possible to improve the characteristics of the erase operation.

Referring to FIG. 4A, the MoS₂ channel layer of a monolayer has a relatively great band gap energy of about 1.8 eV, and thus, a length of the BTBT is relatively great. In such a case, the GIDL current is reduced and a relatively small amount of holes are supplied.

Referring to FIG. 4B, the polysilicon channel layer has a relatively small band gap energy of about 1.1 eV, and thus, a length of the BTBT is relatively small. Accordingly, the GIDL current may be increased and a great amount of holes may be supplied. For reference, a MoS₂ channel layer in a bulk state also has a relatively small band gap energy of about 1.2 eV, and thus, the GIDL current may be relatively great and a great amount of holes may be supplied.

Considering this, by forming the select transistor using the polysilicon channel layer or the MoS₂ channel layer in the bulk state, it is possible to improve the characteristics of the erase operation of the semiconductor device. In addition, by forming the source select transistor and/or the drain select transistor using the polysilicon channel layer or the MoS₂ channel layer in the bulk state and forming the memory cell using the MoS₂ channel layer of the monolayer, it is possible to improve both the cell current and the erase characteristics.

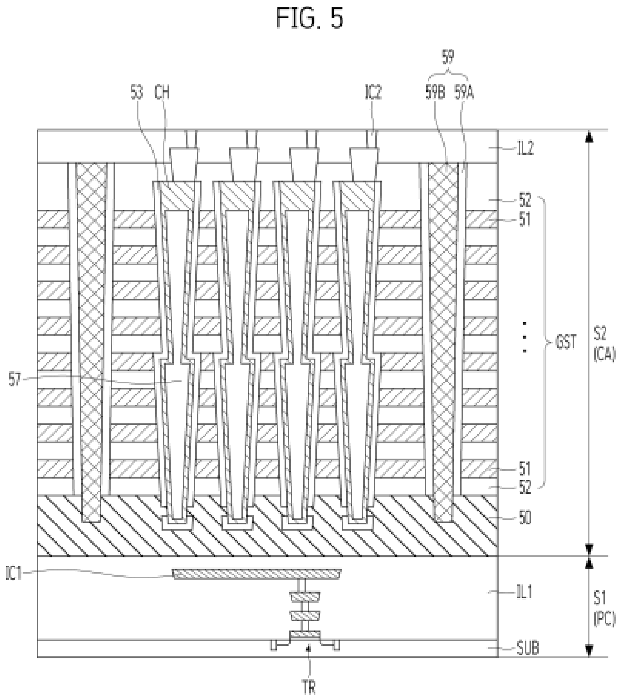

FIG. 5 is a diagram illustrating the structure of a semiconductor device in accordance with an embodiment of the present disclosure. Hereinafter, any content overlapping with the previously described content may be omitted.

Referring to FIG. 5, the semiconductor device may include a first semiconductor structure S1 and a second semiconductor structure S2. The second semiconductor structure S2 may be disposed above the first semiconductor structure S1 or the first semiconductor structure S1 may be disposed above the second semiconductor structure S2.

The first semiconductor structure S1 may include a peripheral circuit PC. The peripheral circuit PC may include a row decoder, a page buffer, an input/output circuit, a logic circuit, and the like. As an example, the first semiconductor structure S1 may include a substrate SUB, a transistor TR, a first interconnection structure IC1, and a first interlayer insulating layer IL1. The transistor TR may belong to the peripheral circuit PC. The first interconnection structure IC1 may be formed in the first interlayer insulating layer IL1, and may be electrically connected to the peripheral circuit PC. The first interconnection structure IC1 may include a via, a wiring line, and the like.

The second semiconductor structure S2 may include a memory cell array CA including stacked memory cells. As an example, the second semiconductor structure S2 may include a source structure 50, a gate structure GST, a channel layer CH, a memory layer 53, an insulating core 57, a slit structure 59, a second interconnection structure IC2, and a second interlayer insulating layer IL2.

The gate structure GST may include conductive layers 51 and insulating layers 52 that are alternately stacked. The channel layer CH may include the first channel layer 14 described with reference to FIGS. 1A and 1B, may include the first channel layer 34, the second channel layer 35, and the third channel layer 36 described with reference to FIGS. 3A to 3E, or may include a combination thereof. The slit structure 59 may pass through the gate structure GST and extend into the source structure 50. The slit structure 59 may include an insulating material, a semiconductor material, and/or a conductive material. As an example, the slit structure 59 may include a source contact 59B and an insulating spacer 59A. The insulating spacer 59A may surround the sidewalls of the source contact 59B which extend through the gate structure GST. The second interconnection structure IC2 may be disposed in the second interlayer insulating layer IL2, and may be electrically connected to the memory cell array CA. The second interconnection structure IC2 may include a via, a wiring line, and the like.

According to the structure described above, by stacking the first semiconductor structure S1 and the second semiconductor structure S2, it is possible to increase the degree of integration of the semiconductor device. By forming the channel layer CH to include at least one of the polysilicon channel layer, the MoS₂ channel layer in the bulk state, or the MoS₂ channel layer of the monolayer, it is possible to improve the operation characteristics of the semiconductor device.

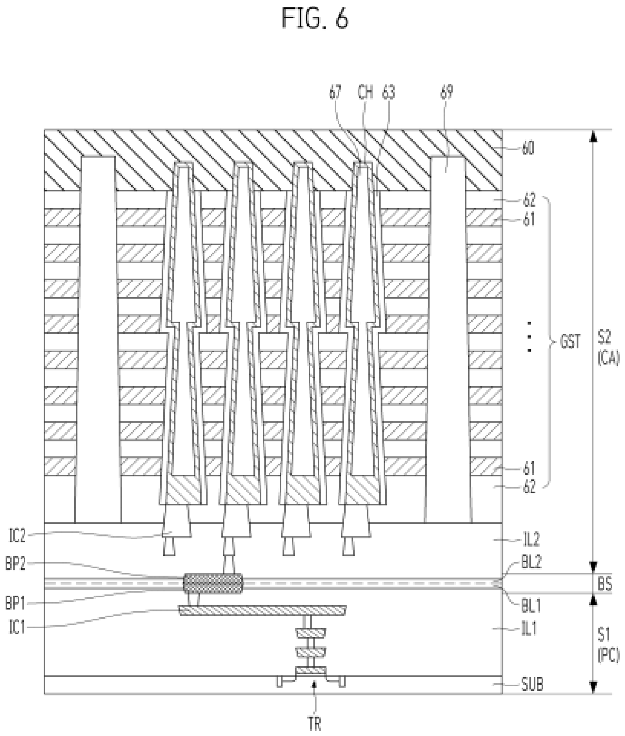

FIG. 6 is a diagram illustrating the structure of a semiconductor device in accordance with an embodiment of the present disclosure. Hereinafter, any content overlapping with the previously described content may be omitted.

Referring to FIG. 6, the semiconductor device may include a first semiconductor structure S1, a second semiconductor structure S2, and a bonding structure BS. The first semiconductor structure S1 may include a peripheral circuit PC, and the second semiconductor structure S2 may include a memory cell array CA.

The first semiconductor structure S1 may include a substrate SUB, a transistor TR, a first interlayer insulating layer IL1, and a first interconnection structure IC1. The transistor TR may belong to the peripheral circuit PC. The first interconnection structure IC1 may be disposed in the first interlayer insulating layer IL1, and may include a via, a wiring line, and the like. The first interconnection structure IC1 may be electrically connected to the peripheral circuit PC.

The second semiconductor structure S2 may include a source layer 60, a gate structure GST, a channel layer CH, a memory layer 63, an insulating core 67, a slit structure 69, a second interlayer insulating layer IL2, and a second interconnection structure IC2.

The gate structure GST may include conductive layers 61 and insulating layers 62 that are alternately stacked. The channel layer CH may include the first channel layer 14 described with reference to FIGS. 1A and 1B, may include the first channel layer 34, the second channel layer 35, and the third channel layer 36 described with reference to FIGS. 3A to 3E, or may include a combination thereof. The source layer 60 may be disposed above the gate structure GST. The source layer 60 may be a layer formed separately from the channel layer CH or may be the source portion of the second channel layer.

The slit structure 69 may pass through the gate structure GST and extend into the source layer 60. The slit structure 69 may include an insulating material, a semiconductor material, and/or a conductive material. The second interconnection structure IC2 may be disposed in the second interlayer insulating layer IL2, and may be electrically connected to the memory cell array CA. The second interconnection structure IC2 may include a via, a wiring line, and the like.

The bonding structure BS may be disposed between the first semiconductor structure S1 and the second semiconductor structure S2. The first semiconductor structure S1 and the second semiconductor structure S2 may be manufactured separately, and may be electrically connected to each other by the bonding structure BS. The memory cell array CA including the gate structure GST and the peripheral circuit PC may be electrically connected to each other by the bonding structure BS.

The bonding structure BS may include a first bonding layer BL1, a second bonding layer BL2, a first bonding pad BPI, and a second bonding pad BP2. The first bonding layer BL1 and the second bonding layer BL2 may contact each other. Also, the first bonding pad BP1 and the second bonding pad BP2 may contact each other. For example, the first bonding layer BL1 and the second bonding layer BL2 may each include SiCN, tetra ethyl ortho silicate (TEOS), or the like. The first bonding pad BP1 may be electrically connected to the first interconnection structure IC1, and the second bonding pad BP2 may be electrically connected to the second interconnection structure IC2. The memory cell array CA and the peripheral circuit PC may be electrically connected to each other through the first bonding pad BP1 and the second bonding pad BP2.

According to the structure described above, the first and second semiconductor structures S1 and S2 may be bonded to each other in a vertical direction. It is thus possible to increase the degree of integration of the semiconductor device. The channel layer CH may include at least one of the polysilicon channel layer, the MoS₂ channel layer in the bulk state, or the MoS₂ channel layer of the monolayer, and it is thus possible to improve the operation characteristics of the semiconductor device.

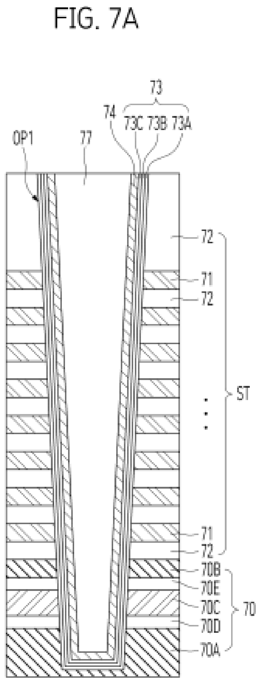

FIGS. 7A to 7D are simplified diagrams for describing a method of manufacturing a semiconductor device in accordance with an embodiment of the present disclosure.
Hereinafter, any content overlapping with the previously described content may be omitted.

Referring to FIG. 7A, a source structure 70 is formed. The source structure 70 may include a first source layer 70A, a second source layer 70B, and a source sacrificial layer 70C. The source sacrificial layer 70C may be formed between the first source layer 70A and the second source layer 70B. The source structure 70 may further include a first protective layer 70D and a second protective layer 70E. As an example, the first source layer 70A, the first protective layer 70D, the source sacrificial layer 70C, the second protective layer 70E, and the second source layer 70B may be sequentially formed. The first source layer 70A, the second source layer 70B, and the source sacrificial layer 70C may each include polysilicon. The first protective layer 70D and the second protective layer 70E may each include oxide.

Subsequently, a stack ST is formed on the source structure 70. The stack ST may include first material layers 71 and second material layers 72 that are alternately stacked. The first material layers 71 may be used to form stacked gate lines, and the second material layers 72 may be used to form insulating layers. As an example, the first material layers 71 may each include a sacrificial material such as nitride, and the second material layers 72 may each include an insulating material such as oxide. As an example, the first material layers 71 may each include a conductive material such as polysilicon or metal, and the second material layers 72 may each include an insulating material such as oxide.

Subsequently, a first opening OP1 is formed in the stack ST. The first opening OP1 may pass through the stack ST and extend into the source structure 70. As an example, the first opening OP1 may penetrate through the stack ST, the second source layer 70B, the second protective layer 70E, the source sacrificial layer 70C, and the first protective layer 70D, and may extend into the first source layer 70A.

Subsequently, a memory layer 73 may be formed in the first opening OP1. As an example, a blocking layer 73A, a data storage layer 73B, and/or a tunneling layer 73C may be formed in the first opening OP1. Subsequently, a first channel layer 74 may be formed in the memory layer 73. The first channel layer 74 may include MoS₂ of a monolayer and/or MoS₂ in a bulk state. Subsequently, an insulating core 77 may be formed in the first channel layer 74.

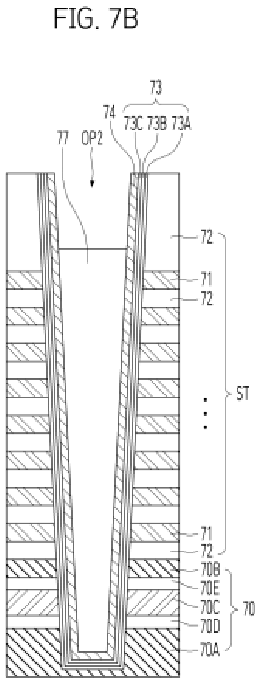

Referring to FIG. 7B, a second opening OP2 may be formed by etching the insulating core 77. The insulating core 77 may be etched so that an upper surface of the insulating core 77 is disposed higher than an upper surface of the uppermost first material layer 71. As an example, the insulating core 77 may be etched using a dry cleaning process. In this case, the insulating core 77 may be selectively etched without etching the first channel layer 74, and inner walls of the first channel layer 74 may be exposed.

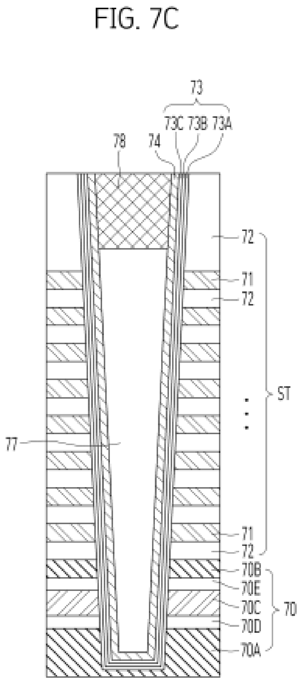

Referring to FIG. 7C, a channel pad 78 may be formed in the second opening OP2 over the insulating core 77. The channel pad 78 may contact the inner walls of the first channel layer 74. The channel pad 78 may include, for example, polysilicon.

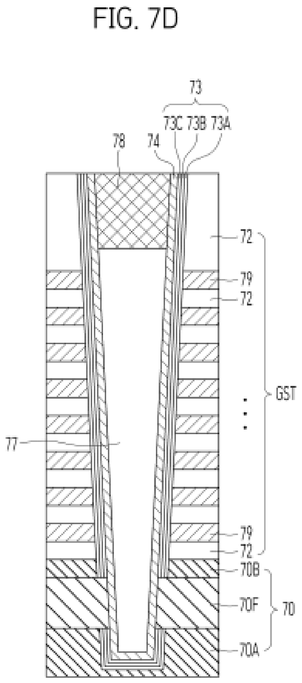

Referring to FIG. 7D, a slit (not illustrated) may be formed in the stack ST, and the source sacrificial layer 70C may be removed through the slit. Following the removal of the source sacrificial layer 70C, the memory layer 73 may be etched to expose the first channel layer 74. In a process of etching the memory layer 73, the first protective layer 70D and the second protective layer 70E may be etched together. Subsequently, a third source layer 70F connected to the first channel layer 74 may be formed. Through this, a source structure 70 including the first source layer 70A, the second source layer 70B, and the third source layer 70F may be formed.

Subsequently, the first material layers 71 may be replaced with third material layers 79. As an example, the third material layers 79 may be formed after the first material layers 71 are removed through the slit. The third material layers 79 are used to form gate lines such as source select lines, drain select lines, and word lines, and may each include metal such as tungsten or molybdenum. Through this, a gate structure GST including the second material layers 72 and the third material layers 79 that are alternately stacked may be formed.

For reference, when the first material layers 71 each include a conductive material, a replacement process may be omitted. In such a case, the first material layers 71 may be used as the gate lines, and the stack ST may be used as the gate structure GST.

According to the method described above, the first channel layer 74 including MoS₂ of the monolayer and/or MoS₂ in the bulk state may be formed. The channel pad 78 including polysilicon may be formed inside the first channel layer 74. Because the first channel layer 74 surrounds sidewalls of the channel pad 78, the first channel layer 74 may be formed as a main current path, and a cell current may be improved.

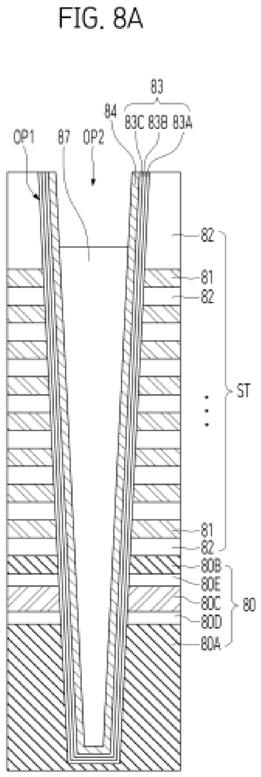

FIGS. 8A to 8F are simplified diagrams for describing a method of manufacturing a semiconductor device in accordance with an embodiment of the present disclosure.
Hereinafter, any content overlapping with the previously described content may be omitted.

Referring to FIG. 8A, a source structure 80 is formed. The source structure 80 may include a first source layer 80A, a second source layer 80B, a source sacrificial layer 80C, a first protective layer 80D, and a second protective layer 80E. Subsequently, a stack ST is formed on the source structure 80. The stack ST may include first material layers 81 and second material layers 82 that are alternately stacked.

Subsequently, a first opening OP1 is formed in the stack ST, and a memory layer 83 is formed in the first opening OP1. The memory layer 83 may include a blocking layer 83A, a data storage layer 83B, and/or a tunneling layer 83C. Subsequently, a first channel layer 84 may be formed in the first opening OP1. The first channel layer 84 may include MoS₂ of a monolayer and/or MoS₂ in a bulk state. Subsequently, an insulating core 87 may be formed in the first channel layer 84, and a second opening OP2 exposing inner walls of the first channel layer 84 may be formed by etching the insulating core 87.

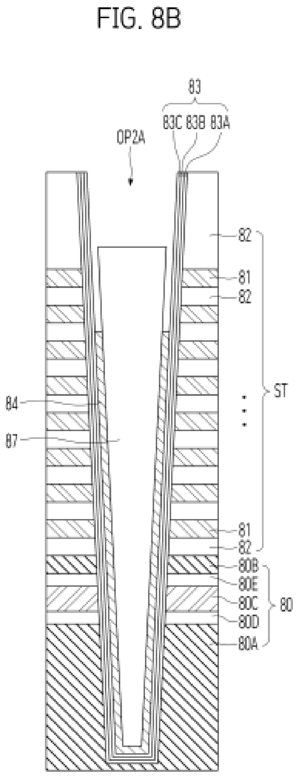

Referring to FIG. 8B, the first channel layer 84 exposed through the second opening OP2 may be etched. Through this, the second opening OP2 may extend downward, and sidewalls of the insulating core 87 may be exposed through the extending second opening OP2A. As an example, a portion of the first channel layer 84 corresponding to a drain select line may be etched, and the second opening OP2A may extend up to a level corresponding to the drain select line.

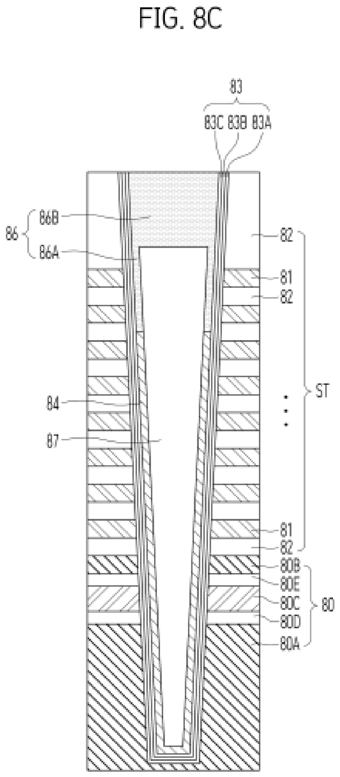

Referring to FIG. 8C, a third channel layer 86 may be formed in the second opening OP2A. The third channel layer 86 may be disposed above the insulating core 87 and the first channel layer 84. The third channel layer 86 may include a channel portion 86A extending along the sidewalls of the insulating core 87 and a pad portion 86B disposed above the insulating core 87. The third channel layer 86 may include, for example, polysilicon.

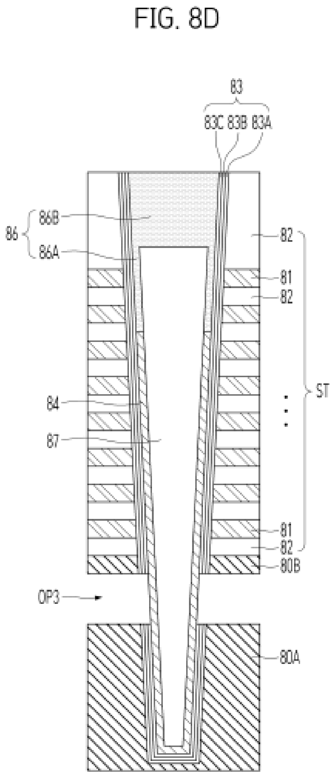

Referring to FIG. 8D, a slit (not illustrated) may be formed in the stack ST, and a third opening OP3 may be formed by removing the source sacrificial layer 80C through the slit. Subsequently, the first channel layer 84 may be exposed by etching the memory layer 83 through the third opening OP3.

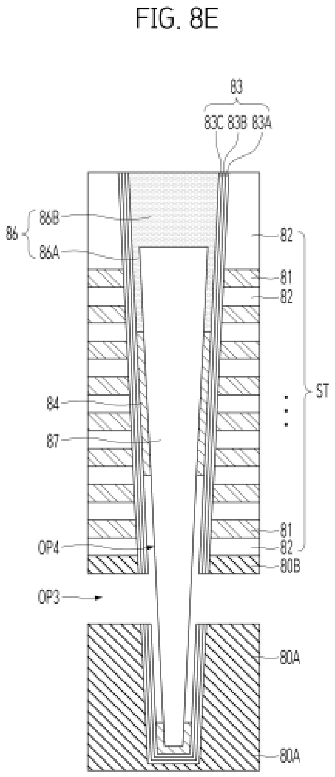

Referring to FIG. 8E, a fourth opening OP4 extending along the sidewalls of the insulating core 87 may be formed by etching the first channel layer 84. The sidewalls of the insulating core 87 and inner walls of the memory layer 83 may be exposed by the fourth opening OP4. As an example, a portion of the first channel layer 84 corresponding to a source select line may be etched, and the fourth opening OP4 may be formed at a level corresponding to the source select line.

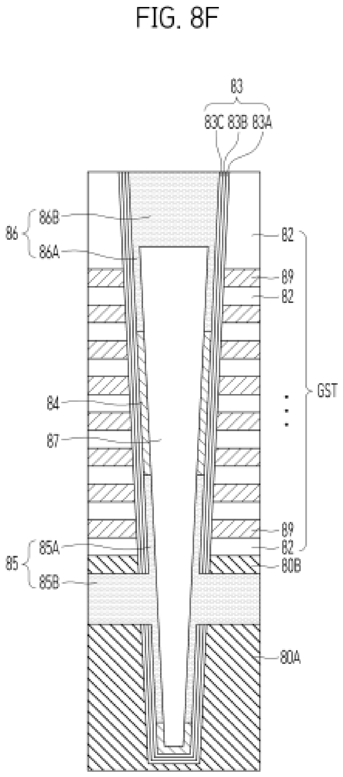

Referring to FIG. 8F, a second channel layer 85 may be formed in the third and fourth openings OP3 and OP4. The second channel layer 85 may include, for example, polysilicon. The second channel layer 85 may include a channel portion 85A and a source portion 85B connected to the channel portion 85A. The channel portion 85A may be disposed in the fourth opening OP4, and the source portion 85B may be disposed in the third opening OP3. The channel portion 85A may surround the sidewalls of the insulating core 87, and may extend between the insulating core 87 and the memory layer 83. The source portion 85B may be disposed between the first source layer 80A and the second source layer 80B. The source portion 85B may be used as a source structure together with the first and second source layers 80A and 80B.

Subsequently, the first material layers 81 may be replaced with third material layers 89, and a gate structure GST may be formed.

According to the method described above, the first channel layer 84 including MoS₂ of the monolayer and/or MoS₂ in the bulk state may be formed, and the second channel layer 85 and the third channel layer 86 each including polysilicon may be formed. Accordingly, it is possible to not only improve the cell current but also improve the operation characteristics of the semiconductor device.

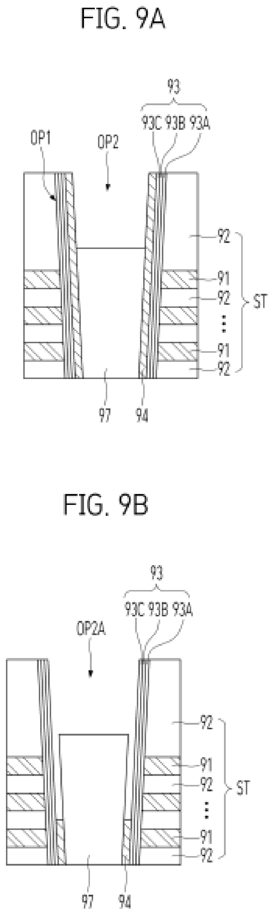

FIGS. 9A to 9D are simplified diagrams for describing a method of manufacturing a semiconductor device in accordance with an embodiment of the present disclosure.
Hereinafter, any content overlapping with the previously described content may be omitted.

Referring to FIG. 9A, a stack ST including first material layers 91 and second material layers 92 that are alternately stacked is formed. Subsequently, a first opening OP1 is formed in the stack ST, and a memory layer 93, and a first channel layer 94 may be formed sequentially in the first opening OP1. The memory layer 93 may include at least one of a blocking layer 93A, a data storage layer 93B, and a tunneling layer 93C. The first channel layer 94 may include MoS₂ of a monolayer and/or MoS₂ in a bulk state.

Subsequently, an insulating core 97 may be formed in the first channel layer 94, and a second opening OP2 exposing inner walls of the first channel layer 94 may be formed by etching the insulating core 97.

Referring to FIG. 9B, the first channel layer 94 exposed through the second opening OP2 may be etched. Through this, the second opening OP2 may extend downward, and sidewalls of the insulating core 97 may be exposed through the extending second opening OP2A.

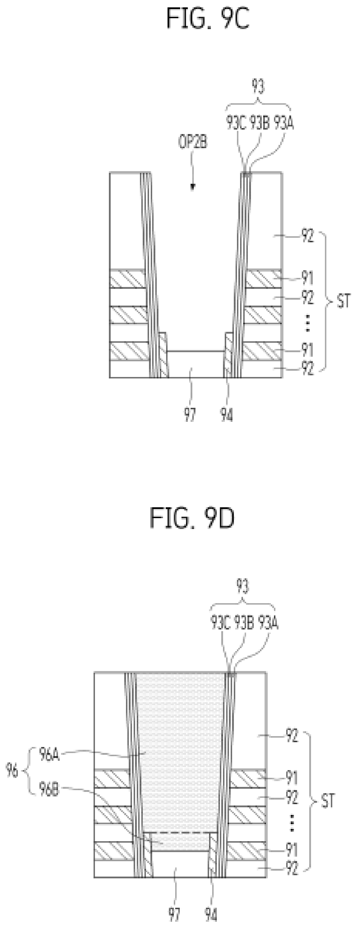

Referring to FIG. 9C, the insulating core 97 exposed through the second opening OP2A may be etched. Through this, the second opening OP2A may extend downward, and the inner walls of the first channel layer 94 may be exposed through the extending second opening OP2B. The first channel layer 94 may protrude more than an upper surface of the insulating core 97.

Referring to FIG. 9D, a third channel layer 96 may be formed in the second opening OP2B. The third channel layer 96 may be disposed above the insulating core 97 and the first channel layer 94. The third channel layer 96 may include a channel portion 96A and a protrusion portion 96B protruding from a lower surface of the channel portion 96A. The channel portion 96A may be disposed above the insulating core 97 and the first channel layer 94, and may penetrate through drain select lines. The protrusion portion 96B may be disposed above the insulating core 97, and may protrude to the inside of the first channel layer 94 to contact the inner walls of the first channel layer 94.

According to the method described above, the first channel layer 94 including MoS₂ of the monolayer and/or MoS₂ in the bulk state may be formed, and the third channel layer 96 including polysilicon may be formed. Accordingly, it is possible to not only improve the cell current but also improve the operation characteristics of the semiconductor device.

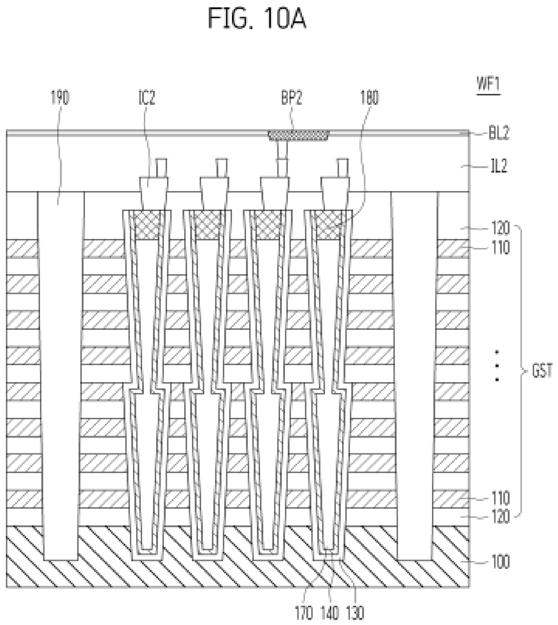

FIGS. 10A to 10D are simplified diagrams for describing a method of manufacturing a semiconductor device in accordance with an embodiment of the present disclosure.
Hereinafter, any content overlapping with the previously described content may be omitted.

Referring to FIG. 10A, a first wafer WF1 may be formed. The first wafer WF1 may include a substrate 100, a gate structure GST over the substrate, a first channel layer 140, a memory layer 130, an insulating core 170, a channel pad 180, a slit structure 190, a second interconnection structure IC2, a second interlayer insulating layer IL2, a second bonding layer BL2, and a second bonding pad BP2. The gate structure GST may include conductive layers 110 and insulating layers 120 that are alternately stacked. The first channel layer 140 and the insulating core 170 may be formed to extend into the substrate 100.

The first channel layer 140 and the channel pad 180 may correspond to the first channel layer 14 and the channel pad 18 described above with reference to FIGS. 1A and 1B, respectively. For reference, it is also possible for the semiconductor device not to include the channel pad 180 and to include the first channel layer 34 and the third channel layer 36 described above with reference to FIGS. 3A and 3B.

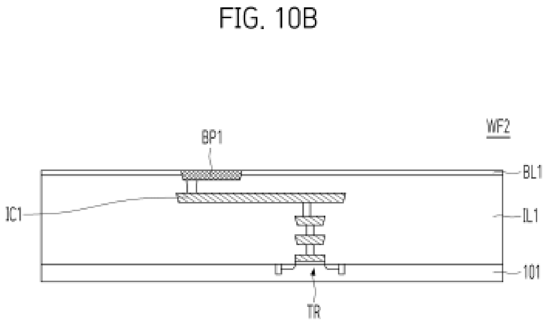

Referring to FIG. 10B, a second wafer WF2 may be formed. The second wafer WF2 may include a substrate 101, a transistor TR, a first interconnection structure IC1, a first interlayer insulating layer IL1, a first bonding layer BL1, and a first bonding pad BP1. The first interconnection structure IC1 may be electrically connected to the transistor TR.

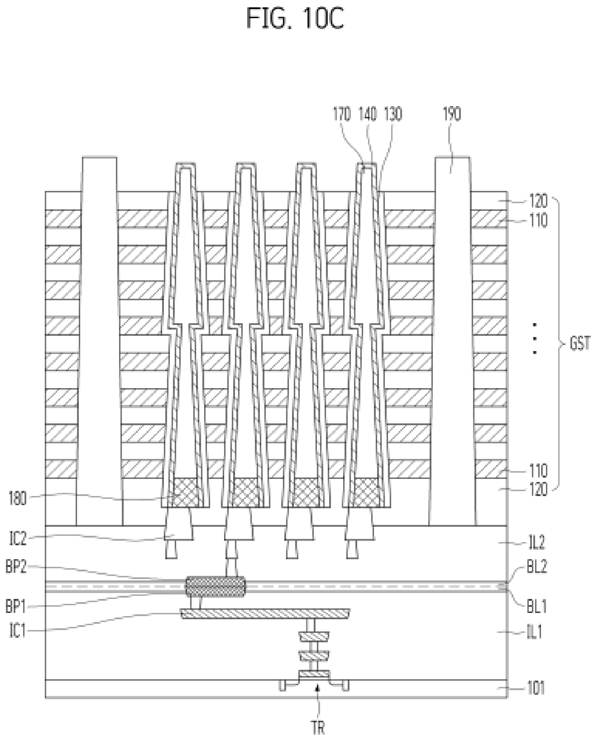

Referring to FIG. 10C, the first wafer WF1 may be inverted so that the substrate 100 is disposed above the gate structure GST, and the first wafer WF1 and the second wafer WF2 are then bonded to each other. The first bonding layer BL1 and the second bonding layer BL2 may be bonded to each other, and the first bonding pad BP1 and the second bonding pad BP2 may be electrically connected to each other.

Subsequently, the substrate 100 may be removed, for example, by using a grinding process, an etch-back process, a planarization process, an etching process, or the like. As the substrate 100 is removed, the memory layer 130 may be exposed. Subsequently, the first channel layer 140 may be exposed by etching the memory layer 130. The first channel layer 140 and the slit structure 190 may protrude from a surface of the gate structure GST.

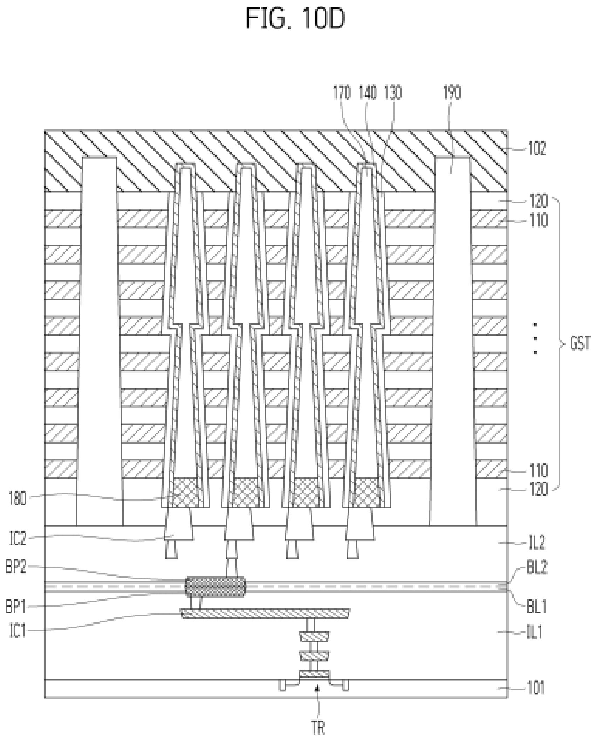

Referring to FIG. 10D, a source layer 102 may be formed on the gate structure GST. The source layer 102 may include, for example, polysilicon.

According to the method described above, the first wafer WF1 including the first channel layer 140 including MoS₂ of the monolayer and/or MoS₂ in the bulk state may be formed. By manufacturing the first wafer WF1 and the second wafer WF2, respectively, and then bonding the first wafer WF1 and the second wafer WF2 to each other to form the semiconductor device, it is possible to improve the manufacturing process of the semiconductor device.

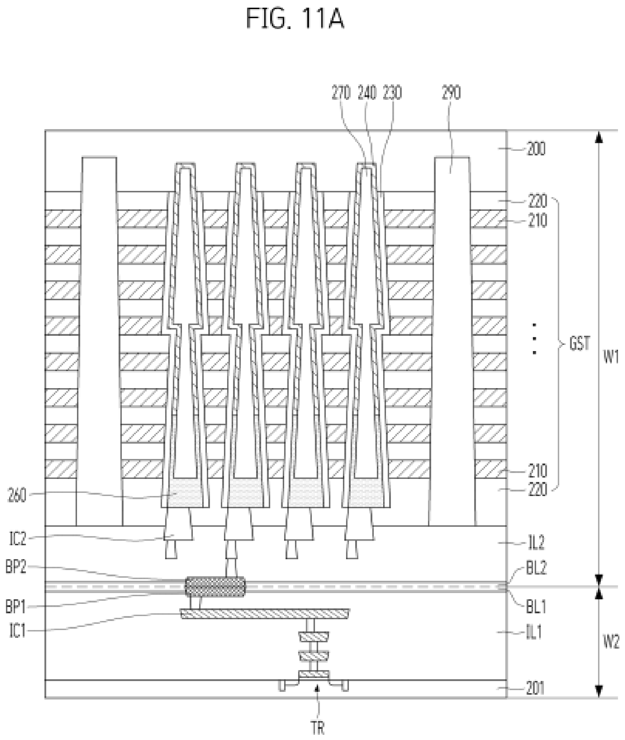

FIGS. 11A to 11C are simplified diagrams for describing a method of manufacturing a semiconductor device in accordance with an embodiment of the present disclosure.
Hereinafter, any content overlapping with the previously described content may be omitted.

Referring to FIG. 11A, first and second wafers WF1 and WF2 may be formed. The first wafer WF1 may include a substrate 200, a gate structure GST, a first channel layer 240, a third channel layer 260, a memory layer 230, an insulating core 270, a slit structure 290, a second interconnection structure IC2, a second interlayer insulating layer IL2, a second bonding layer BL2, and a second bonding pad BP2. The gate structure GST may include conductive layers 210 and insulating layers 220 that are alternately stacked.

The second wafer WF2 may include a substrate 201, a transistor TR, a first interconnection structure IC1, a first interlayer insulating layer IL1, a first bonding layer BL1, and a first bonding pad BP1.

Subsequently, the first wafer WF1 and the second wafer WF2 are bonded to each other. The substrate 200 may be disposed above the gate structure GST, and a rear surface of the substrate 200 may be exposed.

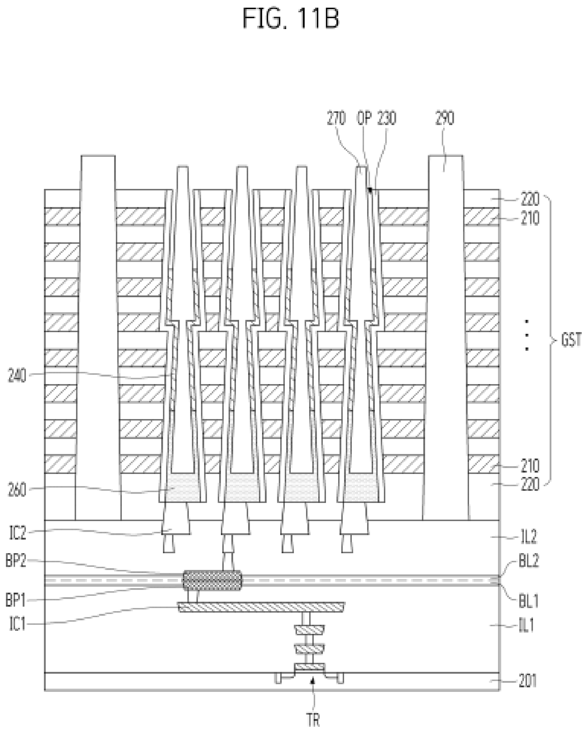

Referring to FIG. 11B, the memory layer 230 may be exposed by removing the substrate 200. Subsequently, the first channel layer 240 may be exposed by etching the memory layer 230. Subsequently, an opening OP may be formed by etching the first channel layer 240. The opening OP may extend between the insulating core 270 and the memory layer 230, and may be disposed to correspond to a source select line.

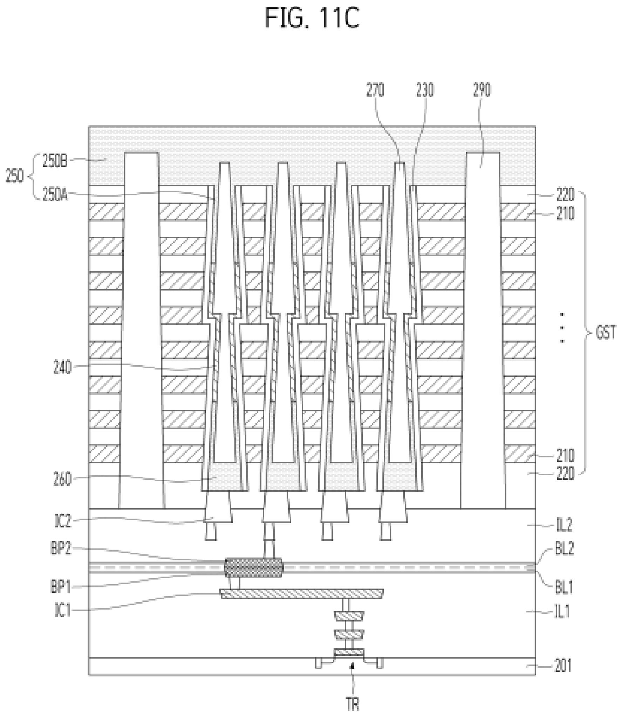

Referring to FIG. 11C, a second channel layer 250 may be formed on the gate structure GST. The second channel layer 250 may include a source portion 250B and a channel portion 250A connected to the source portion 250B. The source portion 250B may be disposed above the gate structure GST, and may extend along a surface of the gate structure GST. The channel portion 250A may be disposed in the opening OP, and may extend along sidewalls of the insulating core 270 and be connected to the first channel layer 240. The second channel layer 250 may include, for example, polysilicon.

According to the method described above, the first wafer WF1 including the first channel layer 240 including MoS₂ of the monolayer and/or MoS₂ in the bulk state and the third channel layer 260 including polysilicon may be formed. After the first wafer WF1 and the second wafer WF2 are bonded to each other, the second channel layer 250 including polysilicon may be formed. Accordingly, the manufacturing process of the semiconductor device may be improved, and the operation characteristics of the semiconductor device may be improved.

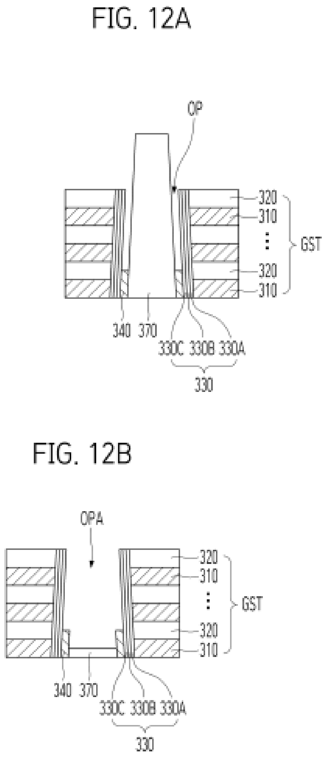

FIGS. 12A to 12C are simplified diagrams for describing a method of manufacturing a semiconductor device in accordance with an embodiment of the present disclosure.
Hereinafter, any content overlapping with the previously described content may be omitted.

FIG. 12A may correspond to FIG. 11B described above. A gate structure GST may include conductive layers 310 and insulating layers 320 that are alternately stacked. A memory layer 330 may include a blocking layer 330A, a data storage layer 330B, and a tunneling layer 330C. Sidewalls of an insulating core 370 and inner walls of the memory layer 330 may be exposed through an opening OP.

Referring to FIG. 12B, the opening OP may be expanded by etching the insulating core 370. Inner walls of a first channel layer 340 may be exposed by the expanded opening OPA. An upper surface of the insulating core 370 may be disposed lower than an upper surface of the first channel layer 340.

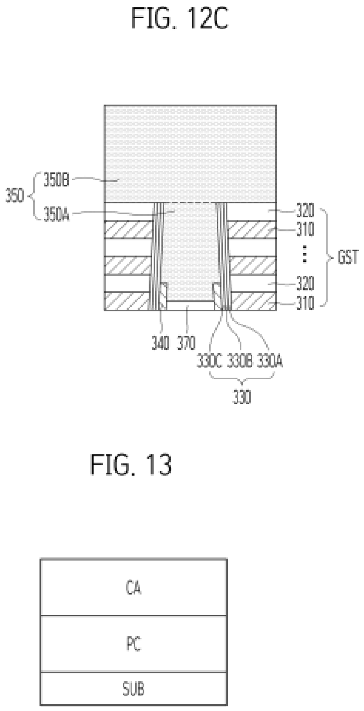

Referring to FIG. 12C, a second channel layer 350 may be formed. The second channel layer 350 may include a source portion 350B and a channel portion 350A connected to the source portion 350B. The source portion 350B may be disposed above the gate structure GST, and may extend along a surface of the gate structure GST. The channel portion 350A may extend into the gate structure GST, and may contact the inner walls of the first channel layer 340.

According to the method described above, the second channel layer 350 may protrude to the inside of the first channel layer 340, and sidewalls of the second channel layer 350 and the inner walls of the first channel layer 340 may contact each other. Accordingly, a contact area between the second channel layer 350 and the first channel layer 340 may be increased, and contact resistance between the second channel layer 350 and the first channel layer 340 may be reduced.

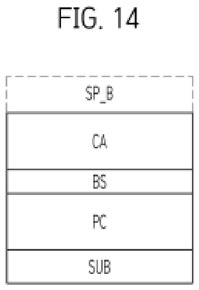

The structures and the methods according to the above-described embodiments may be applied to semiconductor devices having various structures. FIGS. 13 and 14 illustrate schematic configurations of semiconductor devices to which the above-described embodiments are applicable.

FIG. 13 is a configuration diagram of a semiconductor device in accordance with an embodiment of the present disclosure.

Referring to FIG. 13, the semiconductor device may include a substrate SUB, a peripheral circuit PC, and a memory cell array CA. For example, the peripheral circuit PC and the memory cell array CA may be formed on the same substrate.

The substrate SUB may include a semiconductor material. As an example, the semiconductor material may include at least one of a group IV semiconductor, a group III-V compound semiconductor, and a group II-VI compound semiconductor. For example, the group IV semiconductor may include single crystal silicon (Si), polycrystalline silicon, germanium (Ge), or silicon germanium (SiGe). The group III-V compound semiconductor may include GaAs, GaN, GaP, GaAsP, GaInAsP, AlAs, AlGa, InP, InSb, or InGaAs. The group II-VI compound semiconductor may include ZnS, ZnO, or CdS.

The substrate SUB may include a dielectric layer. The substrate SUB may be a silicon-on-insulator (SOI) substrate, a germanium-on-insulator (GeOI) substrate, or a glass substrate. The substrate SUB may include an organic material. As an example, the substrate SUB may include graphene.

The substrate SUB may be a bulk wafer or an epitaxial layer grown by a selective epitaxial growth (SEG) method. The substrate SUB may be a layer formed by a metal induced lateral crystallization (MILC) method, and may partially include metal. The substrate SUB may have a single crystalline, polycrystalline, or amorphous state. The substrate SUB may include group II, group III, group IV, group V, or group VI impurities. As an example, the substrate SUB may include an n-well region doped with n-type impurities and/or a p-well region doped with p-type impurities.

The peripheral circuit PC may be disposed between the substrate SUB and the memory cell array CA. The peripheral circuit PC may include a row decoder, a column decoder, a page buffer, a logic circuit, a control circuit, a sense amplifier, an input/output circuit, and the like. As an example, the peripheral circuit PC may include an N-channel metal oxide semiconductor (NMOS) transistor, a P-channel metal oxide semiconductor (PMOS) transistor, a resistor, a capacitor, and the like. The peripheral circuit PC may further include an interconnection structure. The interconnection structure may be used as a path for transmitting an operation voltage, and may include a contact plug, a wiring line, and the like.

The memory cell array CA may include memory cells. As an example, the memory cell array CA may include memory strings connected between a source line and a bit line, and each memory string may include stacked memory cells. As an example, the memory cell array CA may include memory cells connected between a word line and the bit line. The memory cell array CA may further include an interconnection structure.

FIG. 14 is a configuration diagram of a semiconductor device in accordance with an embodiment of the present disclosure.

Referring to FIG. 14, the semiconductor device may include a substrate SUB, a peripheral circuit PC, a bonding structure BS, and a memory cell array CA. For example, the peripheral circuit PC and the memory cell array CA may be formed on separate substrates, respectively, and then bonded to each other. The semiconductor device may further include a support base SP_B.

The substrate SUB may be used as a support in a process of forming the peripheral circuit PC. The support base SP_B may be used as a support in a process of forming the memory cell array CA. As an example, a first wafer including the memory cell array CA and a second wafer including the peripheral circuit PC may be manufactured, respectively, and then electrically connected to each other by the bonding structure BS. After the first wafer and the second wafer are bonded to each other, the support base SP_B of the first wafer may be at least partially removed. The support base SP_B may be completely removed or may partially remain on the memory cell array CA.

The support base SP_B may be a semiconductor substrate, an insulating substrate, a silicon-on-insulator (SOI) substrate, a germanium-on-insulator (GeOI) substrate, or the like. The support base SP_B may be a bulk wafer, an epitaxial layer grown by a selective epitaxial growth (SEG) method, or a layer formed by a metal induced lateral crystallization (MILC) method. The support base SP_B may have a single crystalline, polycrystalline, or amorphous state. The support base SP_B may include group II, group III, group IV, group V, or group VI impurities.

The bonding structure BS may be used to connect the memory cell array CA and the peripheral circuit PC to each other. As an example, the bonding structure BS may bond the memory cell array CA and the peripheral circuit PC to each other by a wafer-on-wafer bonding method, a chip-on-wafer bonding method, a chip-on-chip bonding method, or the like. The bonding structure BS may include a bonding pad, a bonding layer, a bonding interface, and the like. The bonding pad may include metal such as copper or aluminum and/or alloys thereof. The bonding interface may include a nonmetal-nonmetal interface, a metal-metal interface, or the like. The memory cell array CA and the peripheral circuit PC may be electrically connected to each other by the bonding structure BS.

For reference, it is also possible for interconnection structures included in the memory cell array CA and/or the peripheral circuit PC to be directly connected to each other without a bonding pad. As an example, a bonding layer included in the memory cell array CA and a bonding layer included in the peripheral circuit PC may be bonded to each other to form a bonding interface, and an interconnection structure included in the memory cell array CA and an interconnection structure included the peripheral circuit PC may be directly connected to each other. Through this, contact plugs, wiring lines, and the like, formed on different wafers may be electrically connected to each other without a separate bonding pad.

Other configurations may be the same as or similar to those described above with reference to FIG. 13.

Moreover, it is also possible for the semiconductor device to have a structure in which embodiments described above with reference to FIGS. 13 and 14 are combined with each other or have a partially modified structure. In embodiments described with reference to FIGS. 13 and 14, locations of the memory cell array CA and the peripheral circuit PC may be changed. At least one memory cell array CA and/or at least one peripheral circuit PC may be additionally bonded in embodiments described with reference to FIGS. 13 and 14. As an example, a portion of the peripheral circuit PC may be disposed in the memory cell array CA.

Although embodiments according to the technical idea of the present disclosure have been described above with reference to the accompanying drawings, this is only for describing the embodiments according to the concepts of the present disclosure, and the present disclosure is not limited to the above embodiments. Various types of substitutions, modifications, changes, and combinations for the embodiments may be made by those skilled in the art, to which the present disclosure pertains, without departing from the technical idea of the present disclosure defined in the following claims, and it should be construed that these substitutions, modifications, changes, and combinations belong to the scope of the present disclosure. Furthermore, the embodiments may be combined to form additional embodiments.

## Claims

1. A semiconductor device comprising:
a gate structure including a source select line, a drain select line, and word lines stacked between the source select line and the drain select line;
first, second and third channel layers; and
an insulating core disposed inside the first channel layer,
wherein the second channel layer penetrates through the source select line and includes polysilicon;
wherein the third channel layer penetrates through the drain select line and includes polysilicon; and
wherein the first channel layer penetrates through the word lines, connected between the second channel layer and the third channel layer, and includes molybdenum disulfide (MoS₂).

2. The semiconductor device of claim 1, wherein the third channel layer comprises:
a pad portion disposed above the insulating core; and
a channel portion extending along sidewalls of the insulating core.

3. The semiconductor device of claim 1, wherein the third channel layer comprises:
a channel portion disposed above the insulating core and the first channel layer; and
a protrusion portion protruding from the channel portion to an inside of the first channel layer.

4. The semiconductor device of claim 1, wherein the second channel layer comprises:
a channel portion surrounding the insulating core and extending between the insulating core and the gate structure; and
a source portion extending along a surface of the gate structure.

5. The semiconductor device of claim 4, further comprising:
a first source layer disposed below the source portion; and
a second source layer disposed between the source portion and the gate structure.

6. The semiconductor device of claim 4, wherein the source portion is disposed above the gate structure, and the channel portion protrudes from a lower surface of the source portion.

7. The semiconductor device of claim 1, wherein the second channel layer comprises:
a source portion extending along a surface of the gate structure; and
a channel portion protruding from the source portion and in contact with inner walls of the first channel layer.

8. A semiconductor device comprising:
a gate structure including conductive layers and insulating layers that are alternately stacked;
an insulating core extending through the gate structure;
a first channel layer surrounding the insulating core, disposed between the insulating core and the gate structure, and including molybdenum disulfide (MoS₂); and
a second channel layer including a source portion extending along a surface of the gate structure and a channel portion extending into the gate structure and connected to the first channel layer, and including polysilicon.

9. The semiconductor device of claim 8, further comprising a channel pad disposed above the insulating core and including polysilicon,
wherein the first channel layer surrounds sidewalls of the channel pad.

10. The semiconductor device of claim 8, further comprising a third channel layer including a pad portion disposed above the insulating core and a channel portion extending along sidewalls of the insulating core and connected to the first channel layer.

11. The semiconductor device of claim 8, further comprising a third channel layer including a channel portion disposed above the insulating core and the first channel layer and a protrusion portion protruding from the channel portion and in contact with inner walls of the first channel layer.

12. The semiconductor device of claim 8, wherein the channel portion of the second channel layer surrounds the insulating core, and extends between the insulating core and the gate structure.

13. The semiconductor device of claim 12, further comprising:
a first source layer disposed below the source portion; and
a second source layer disposed between the source portion and the gate structure.

14. The semiconductor device of claim 12, wherein the source portion is disposed above the gate structure, and the channel portion protrudes from a lower surface of the source portion.

15. The semiconductor device of claim 8, wherein the source portion is disposed above the gate structure, and the channel portion is in contact with inner walls of the first channel layer.
